# EUROPÄISCHE PATENTSCHRIFT

(11) **EP 3 791 701 B1**
(45) Veröffentlichungstag und Bekanntmachung des Hinweises auf die Patenterteilung: **01.05.2024**
(21) Anmeldenummer: 19711595.9
(22) Anmeldetag: 16.03.2019
(51) Int. Cl.: H05K 7/14, H05K 7/18

(54) **RACK SOWIE SERVER- ODER NETZWERKSCHRANK MIT EINEM RACK**
RACK AND SERVER CABINET OR NETWORK CABINET HAVING A RACK
BAIE AINSI QU'ARMOIRE DE SERVEUR OU DE RÉSEAU COMPRENANT UNE BAIE

(43) Veröffentlichungstag der Anmeldung: 17.03.2021
(73) Patentinhaber: EFB-Elektronik GmbH, 33719 Bielefeld (DE)
(72) Erfinder: HARMS, Andreas, 32105 Bad Salzuflen (DE); NELLES, Marcus, 33102 Paderborn (DE); SÖRENSEN, Kim H., 2760 Malov (DK); KJAERHOLT SCHMIDT, Kristian, 4390 Vipperød (DK)
(74) Vertreter: Schober, Mirko
(86) Internationale Anmeldenummer: PCT/EP2019/056638
(87) Internationale Veröffentlichungsnummer: WO 2020/187395

(56) Entgegenhaltungen:
- EP-A1- 2 796 121
- EP-B1- 2 796 121

## Beschreibung

### TECHNISCHES GEBIET

Die Erfindung betrifft ein Rack, insbesondere Serverrack oder Netzwerkrack, gemäß dem Oberbegriff von Anspruch 1. Weiterhin betrifft die Erfindung einen Server- oder Netzwerkschrank mit einem solchen Rack mit den Merkmalen in Anspruch 7.

### STAND DER TECHNIK

Miteinander zusammenarbeitende oder thematisch zusammengehörige Geräte und Baugruppen werden üblicherweise zu einer Einheit zusammengefasst. Neben der so eindeutigeren Zuordnung sowie Verkürzung von Verbindungswegen erleichtert dies zudem den Transport. Hierfür haben sich standardisierte Aufbewahrungssysteme etabliert, deren Regalform ein genormtes Aufnahmeraster für die einzelne Geräte und Baugruppen enthält. Offene Ausgestaltungen sind unter dem Begriff "Rack" geläufig, während dessen zumindest bereichsweise Verkleidung mit Tür- oder Wandelementen als Schrank bezeichnet wird. Typische Anwendungsbereiche finden sich beispielsweise in Rechenzentren sowie Labors und Studios, wobei deren jeweiliger Inhalt von Teilen der Netzwerk- und Regeltechnik bis hin zur Musik- und Veranstaltungstechnik reicht. Dabei haben sich im Wesentlichen 19-Zoll-Systeme durchgesetzt, die der Aufnahme von Geräten oder Baugruppen mit einer normierten Breite von 19 Zoll dienen.

Aus DE 10 2015 120 944 A1 geht ein Server-Rack hervor, welches ein Gestell mit vier gegenüberliegend angeordneten Längsprofilen umfasst. Die Längsprofile spannen einen Innenraum zwischen sich auf, so dass die äußeren Abmessungen des Server-Racks im Wesentlichen durch die Position der Längsprofile zueinander bestimmt sind.

Die EP 2 796 121 A1 offenbart einen Rollstuhl, dessen Grundgestell zwei parallel zueinander angeordnete Seitenrahmen mit im Wesentlichen horizontal sowie vertikal orientierten Rohren umfasst. Die Seitenrahmen sind über eine Positionieranordnung miteinander gekoppelt, welche ein Scherenelement und ein Faltscharnier aufweist. Um das Grundgestell möglichst platzsparend zusammenfalten zu können, ist die Positionieranordnung derart beweglich ausgebildet, dass die beiden Seitenrahmen relativ zueinander verlagerbar sind.

Der Transport inhaltsloser Racks beziehungsweise entsprechender Schränke kann montiert oder demontiert erfolgen. Der an sich vorteilhafte, da handlichere und insofern weniger platzintensive Transport im zerlegten Zustand erfordert den anschließenden Zusammenbau vor Ort. Neben dem hierfür notwendigen Geschick sowie dem Vorhalten entsprechender Werkzeuge gestaltet sich dies bisweilen aufwendig und zeitintensiv; etwaige Fehler beim Zusammenbau durch Privatleute oder ungeschultes Personal sind dabei nicht ausgeschlossen.

### DIE ERFINDUNG

Der vorliegenden Erfindung liegt daher die Aufgabe zugrunde, das im Zusammenhang mit dem Rollstuhl bekannte Grundgestellt weiterzuentwickeln, um dessen Anwendungsbereich in Bezug auf ein Rack zu erweitern.

Die Lösung dieser Aufgabe besteht nach der Erfindung in einem Rack mit den Merkmalen von Anspruch 1. Vorteilhafte Ausgestaltungen sind Gegenstand der abhängigen Unteransprüche 2 bis 6. Weiterhin wird die Erfindung durch einen Server- oder Netzwerkschrank, mit den Merkmalen von Anspruch 7 gelöst.

Kern der Erfindung ist eine möglichst bewegliche Verbindung der hauptsächlichen Bestandteile des Racks, durch deren bauliche Verkettung die wesentlichen Verbindungen stets aktiv sind, während die Beweglichkeit ein kompaktes Zusammenlegen und anschließend schnelles Entfalten in den Gebrauchszustand ermöglicht. Hierzu sieht die Erfindung vor, dass die vier Längsprofile des Gestells über eine entsprechend beweglich ausgebildete Positionieranordnung miteinander verbunden sind. Damit ist es möglich, die mit der Positionieranordnung verbundenen Längsprofile relativ zueinander zu verlagern. Auf diese Weise können diese ohne die Notwendigkeit einer Demontage beispielsweise für den Transport einander angenähert werden, um die äußeren Abmessungen des Racks zu minimieren. Vor Ort können die Längsprofile dann quasi werkzeuglos in ihre vorgesehenen Positionen bewegt werden, so dass innerhalb kürzester Zeit die stabile Grundform des Gestells wiederhergestellt ist.

Hierzu umfasst die Positionieranordnung zwei zueinander beabstandete Gestänge. Dabei ist das erste Gestänge mit den zu einer Richtung hin ausgerichteten Endabschnitten der Längsprofile verbunden, die an einem ersten Ende des Gestells gelegen sind. Demgegenüber sind die dem ersten Ende gegenüberliegenden und insofern am zweiten Ende gelegenen Endabschnitte der Längsprofile mit dem zweiten Gestänge verbunden. Damit begrenzen die Längsprofile und die Gestänge den sich zwischen diesen aufspannenden und damit in vorteilhafter Weise ungestörten Innenraum zur Aufnahme etwaiger Geräte und Baugruppen.

Jedes Gestänge der Positionieranordnung besitzt ein Querprofil und wenigstens einen schwenkbar an einem Abschnitt des Querprofils angeordneten Ausleger. Die freien Enden des Querprofils und des Auslegers sind dabei jeweils mit dem zugehörigen Endabschnitt eines Längsprofils verbunden. Besonders bevorzugt kann jede dieser Verbindungen biegesteif ausgeführt sein, um direkt die Stabilität des Gestells zu begründen. In vorteilhafter Weise kann der Ausleger an einem mittleren Abschnitt des Querprofils schwenkbar angeordnet sein, um eine ungestörte Schwenkbarkeit zu ermöglichen. Überdies ergibt sich so die kürzeste Länge für den Ausleger, um das damit verbundene Längsprofil im zugehörigen Eckpunkt eines im Gebrauchszustand im Querschnitt rechteckigen Gestells zu positionieren. Neben einer erhöhten Stabilität ermöglicht dies auch ein möglichst geringes Gewicht.

Weiterhin sind an jedem Querprofil der beiden Gestänge jeweils zwei Ausleger schwenkbar angeordnet. Die Ausleger können dabei zueinander versetzt an einem mittleren Abschnitt des zugehörigen Querprofils angeordnet sein. Zwei der in einem festen Abstand diagonal gegenüberliegend angeordneten Längsprofile sind dabei mit den freien Enden des Querprofils jedes Gestänges verbunden, während die übrigen zwei Längsprofile jeweils mit dem freien Ende des zugehörigen Auslegers jedes Gestänges verbunden sind. So sind die mit den Querprofilen verbundenen Längsprofile stets fest zueinander positioniert, wobei die übrigen beiden Längsprofile über die schwenkbaren Ausleger entsprechend verlagerbar sind. Hierdurch lässt sich ein überaus flacher Transportzustand des Racks erreichen, indem die schwenkbaren Längsprofile jeweils möglichst nah zu einem der anderen beiden Längsprofile hin verlagert werden.

Nach einer besonders bevorzugten Weiterbildung des grundsätzlichen Erfindungsgedankens kann wenigstens ein Teil der Positionieranordnung quer zur Längsrichtung wenigstens eines Längsprofils schwenkbar ausgestaltet sein. Hierdurch lässt sich die räumliche Anordnung der Längsprofile zueinander auf einfache Weise mittels Schwenken verändern, um das Rack in Bezug auf seine äußeren Abmessungen von einem Gebrauchszustand in einen demgegenüber kleineren Transportzustand und wieder zurück zu überführen.

Auch wenn die Längsprofile des Gestells bereits etwaige Aufnahmen oder Mittel zur Aufnahme von Geräten oder Baugruppen besitzen können, wird es als vorteilhaft angesehen, wenn diese insbesondere im Hinblick auf eine ausreichende Durchlüftung entfernt zu etwaigen Geräten oder Baugruppen angeordnet sind. Hierfür sieht die Erfindung eine zusätzliche, im Inneren des Racks befindliche Anordnung vor, die der eigentlichen Aufnahme von Geräten oder Baugruppen dient. Konkret werden hierfür zwei zur Aufnahme von Einschüben ausgebildete Innenrahmen vorgeschlagen, die an der Positionieranordnung befestigt sind. Selbstverständlich können die Innenrahmen auch ein anderweitig ausgestaltetes Raster besitzen, um der genormten Aufnahme von Geräten oder Baugruppen zu entsprechen. Jeder dieser Innenrahmen besitzt zwei Pfosten und zwei die Pfosten miteinander verbindende Riegel. Um dem Kerngedanken der Erfindung zu entsprechen, können die Innenrahmen entsprechend schwenkbar an der Positionieranordnung befestigt sein, um das kompakte Zusammenlegen des Racks in seinen Transportzustand zu unterstützen.

Bevorzugt können die Innenrahmen dabei so ausgestaltet und angeordnet sein, dass sie sich zwischen zwei voneinander beabstandeten Gestängen der Positionieranordnung erstrecken.

Weiterhin ist vorgesehen, dass die Innenrahmen mit zwischen der Positionieranordnung und jedem Längsprofil angeordneten Knotenblechen gekoppelt oder koppelbar sind. Bevorzugt können die Knotenbleche dabei jeweils zwischen einem Längsprofil und einem damit verbundenen Ausleger oder Querprofil der Positionieranordnung angeordnet sein, woraus sich eine hohe Stabilität für das Gestell ergibt.

Nach der Erfindung wird es als besonders vorteilhaft angesehen, wenn die Längsprofile verdrehfest mit der Positionieranordnung verbunden sind. Damit wird die Stabilität nochmals erhöht, während die notwendige Beweglichkeit der Positioniereinheit bevorzugt nur auf die gelenkige Verbindung der an den Querträgern der Positionieranordnung angeordneten Auslegern beschränkt ist.

Das nunmehr vorgestellte erfindungsgemäße Rack ermöglicht ein überaus einfaches Zusammenlegen in einen Transportzustand, wobei es vor Ort auf einfache Weise innerhalb kürzester Zeit in seinen Gebrauchszustand versetzbar ist.

Die Erfindung ist weiterhin auf einen Server- oder Netzwerkschrank gerichtet, welcher ein oben beschriebenes erfindungsgemäßes Rack beinhaltet. Weiterhin ist wenigstens ein Wandelement und/oder Türelement vorgesehen, durch welches das Rack zumindest bereichsweise verkleidet ist.

Die sich hieraus ergebenden Vorteile wurden bereits im Zusammenhang mit der Vorstellung des erfindungsgemäßen Racks näher erläutert, so dass zur Vermeidung von Wiederholungen an dieser Stelle auf die entsprechenden Ausführungen hierzu verwiesen wird. Überdies bewirkt die zumindest bereichsweise Verkleidung des Racks den Schutz der darin anordenbaren Geräte und Baugruppen vor versehentlichem oder unbefugtem Zugriff sowie Beschädigung und Verschmutzung. Insgesamt lässt sich dadurch der optische Gesamteindruck verbessern, wie etwa durch das Bedecken von Verbindungskabeln. Insbesondere das Türelement gestattet in seiner abschließbaren Variante eine wirksame Zugriffskontrolle.

### KURZBESCHREIBUNG DER ZEICHNUNGSABBILDUNG

Die Erfindung wird im Folgenden anhand eines in den Figuren schematisch dargestellten Ausführungsbeispiels näher erläutert:
- Fig. 1: zeigt eine perspektivische Ansicht einer möglichen Ausführungsform eines erfindungsgemäßen Racks.
- Fig. 2: zeigt das Rack aus Fig. 1 in einer Aufsicht im Gebrauchszustand.
- Fig.: 3 bis Fig. 6 zeigen Aufsichten auf das in Fig. 1 gezeigte Rack in verschiedenen Klappzuzständen.
- Fig. 7: zeigt eine perspektivische Ansicht des in Fig. 1 gezeigten Racks im Transportzustand.

### BESTER WEG ZUR AUSFÜHRUNG DER ERFINDUNG

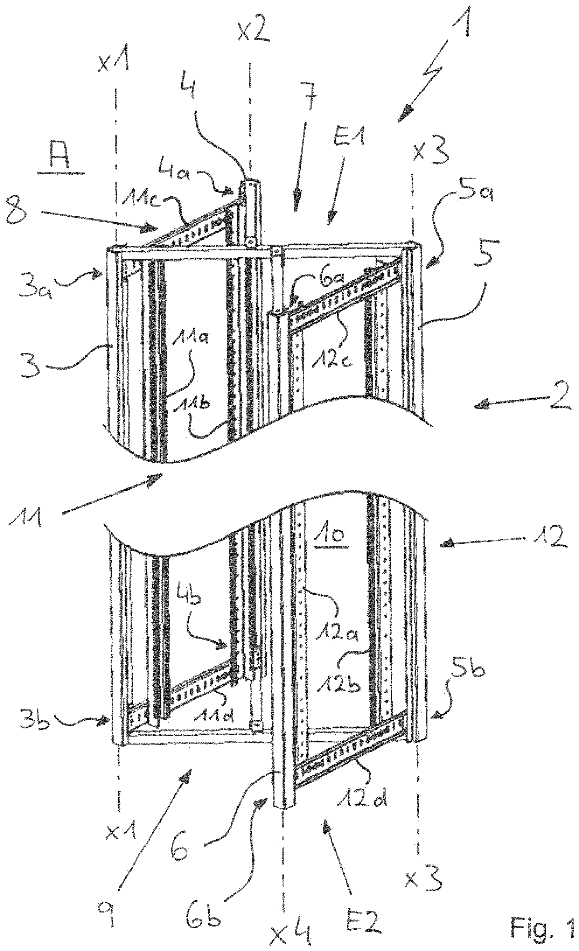

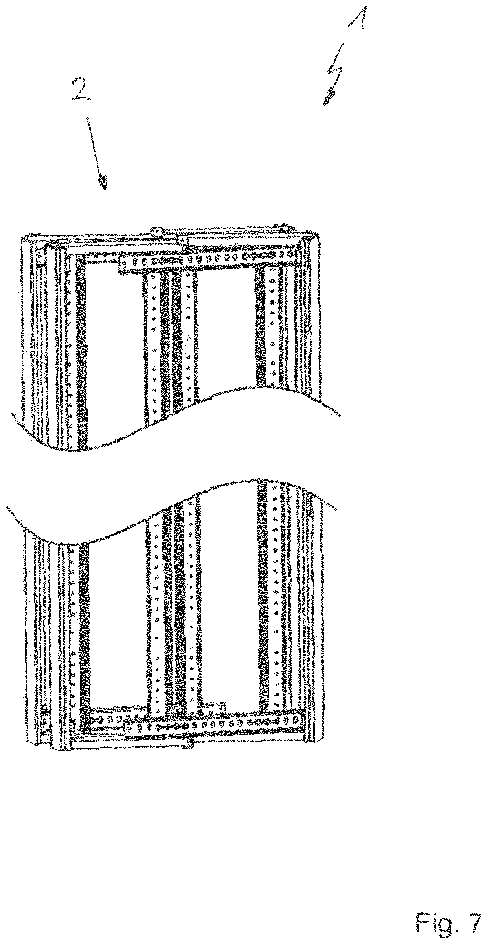

Fig. 1 zeigt eine perspektivische Ansicht eines erfindungsgemäßen Racks 1 in seinem Gebrauchszustand A. Im vorliegend ersichtlichen Gebrauchszustand A ist das Rack 1 zur Aufnahme hier nicht näher gezeigter Geräte und/oder Baugruppen eingerichtet. Hierzu ist das Rack 1 entsprechend klappbar ausgebildet, so dass es zwischen dem Gebrauchszustand A und einem demgegenüber in dessen Abmessungen kleineren Transportzustand B veränderbar ist (vgl. Fig. 7).

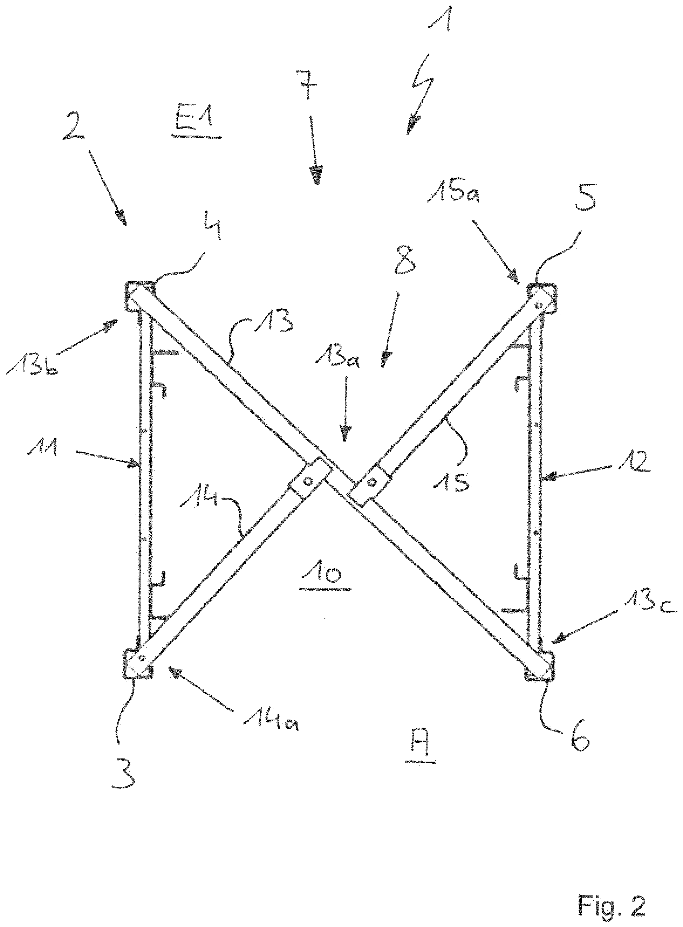

Zur besseren Nachvollziehbarkeit ist die Veränderbarkeit in den später beschriebenen Fig. 2 bis 7 beginnend mit dem Gebrauchszustand A hin zum Transportzustand B näher beschrieben.

Das Rack 1 umfasst ein Gestell 2, welches vorliegend vier, im hier gezeigten Gebrauchszustand A gegenüberliegend angeordnete Längsprofile 3-6 besitzt. Ein imaginärer Hüllkörper der Längsprofile 3-6 bestimmt im Wesentlichen die äußeren Abmessungen des Gestells 2 und insofern des Racks 1. Die Längsprofile 3-6 sind über eine Positionieranordnung 7 miteinander verbunden, über welche sie zueinander positioniert und ausgerichtet sind. Hierbei sind die Längsprofile 3-6 verdrehfest mit der Positionieranordnung 7 verbunden. Erkennbar verlaufen die jeweiligen Längsrichtungen x1-x4 der Längsprofile 3-6 dabei parallel zueinander.

Die Positioniereinrichtung 7 weist zwei mit den Längsprofilen 3-6 verbundene Gestänge 8, 9 auf. Dabei ist das erste Gestänge 8 mit an einem ersten Ende E1 des Gestells 2 gelegenen Endabschnitten 3a-6a der Längsprofile 3-6 verbunden. Das zweite Gestänge 9 ist mit an einem dem ersten Ende E1 gegenüberliegenden zweiten Ende E2 gelegenen Endabschnitten 3b-6b der Längsprofile 3-6 verbunden. Auf diese Weise erstrecken sich die beiden Gestelle 8, 9 jeweils in der Ebene der beiden Enden E1, E2 des Gestells 2, so dass sie unter Ausbildung eines zwischen ihnen und den Längsprofilen 3-6 gelegenen Innenraums 10 des Racks 1 voneinander beabstandet sind. Weiterhin weist das Rack 1 zwei zur Aufnahme von hier nicht näher ersichtlichen Einschüben vorgesehene Innenrahmen 11, 12 auf, welche vorliegend schwenkbar an der Positinieranordnung 7 befestigt sind. Dabei erstrecken die Innenrahmen 11, 12 sich zwischen den beiden Gestängen 8, 9 der Positionieranordnung 7. Im Übergangsbereich zwischen jedem Längsprofil 3-6 und der Positionieranordnung 7 kann jeweils ein hier nicht näher erkennbares Knotenblech angeordnet sein, wobei die Innenrahmen 11, 12 jeweils mit zwei dieser Knotenbleche gekoppelt oder koppelbar sein können. Jeder Innenrahmen 11, 12 besitzt zwei parallel zu den Längsrichtungen x1-x4 der Längsprofile 3-6 verlaufende Pfosten 11a, 11b; 12a, 12b, die jeweils durch zwei quer zu diesen verlaufende Riegel 11c, 11d; 12c, 12d miteinander verbunden sind.

Fig. 2 zeigt das Rack 1 aus Fig. 1 in einer Aufsicht auf das mit Bezug auf die Darstellung von Fig. 1 oben gelegene erste Ende E1. Die weiteren Ausführungen zu dem hierbei ersichtlichen ersten Gestänge 8 gelten für das zweite Gestänge 9 entsprechend. So weist das Gestänge 8 ein sich zwischen zwei der sich diagonal gegenüberliegenden Längsprofile 4, 6 erstreckendes Querprofil 13 auf, an dessen mittlerem Abschnitt 13a zwei zueinander versetzte Ausleger 14, 15 schwenkbar angeordnet sind. Die freien Enden 13b, 13c des Querprofils 13 sind mit den zugehörigen Längsprofilen 4, 6 biegesteif sowie verdrehfest verbunden, wodurch diese in einem festen Abstand zueinander positioniert sind. Demgegenüber sind die beiden übrigen Längsprofile 3, 5 jeweils mit einem freien Ende 14a, 15a der Ausleger 14, 15 biegesteif sowie verdrehfest verbunden. Aufgrund der so gegebenen Beweglichkeit der Positionieranordnung 7 sind die mit ihr verbundenen Längsprofile 3-6 entsprechend relativ zueinander verlagerbar, indem die mit den quer zu den Längsrichtungen x1-x4 schwenkbaren Auslegern 14, 15 verbundenen Längsprofile 3, 5 in ihrer jeweiligen Position veränderbar sind.

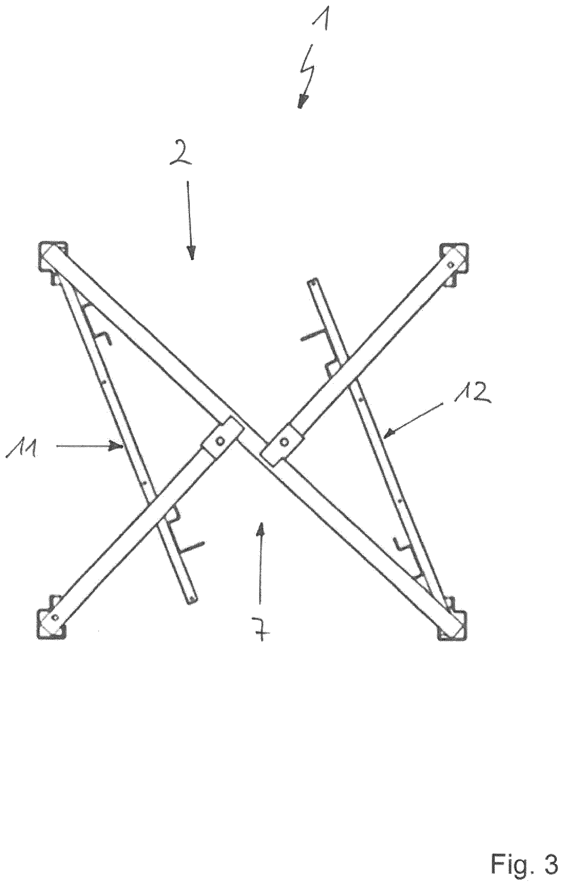

Fig. 3 ist der Beginn der Überführung des Racks 1 von seinem Gebrauchszustand A in seinen Transportzustand B zu entnehmen. Erkennbar wurden die beiden Innenrahmen 11, 12 bereits ein Stück weit in den Innenraum 10 des Racks 1 hinein verschwenkt. Die Positionieranordnung 7 des Gestells 2 weist dabei noch die vorherige Ausrichtung seiner Teile auf.

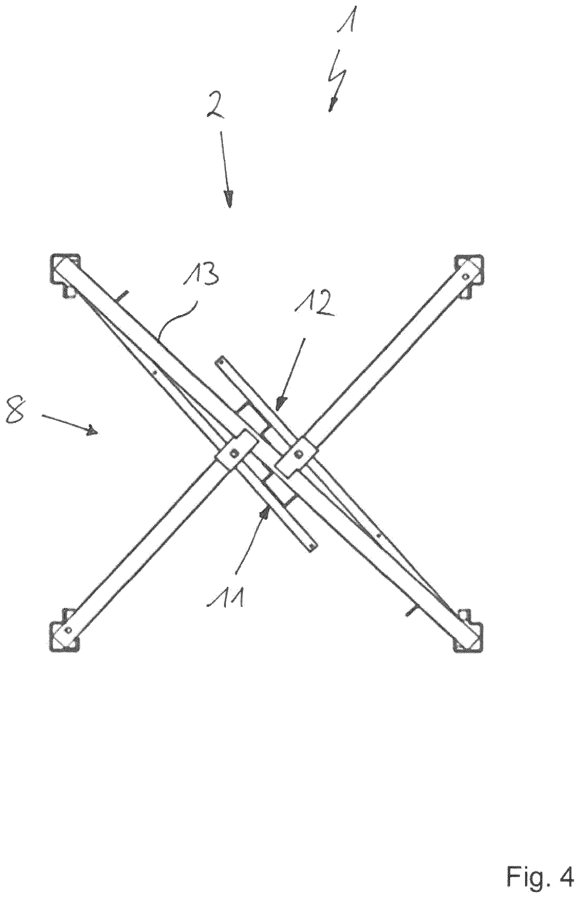

Fig. 4 zeigt den vollständig eingeklappten Zustand der Innenrahmen 11, 12. Erkennbar verlaufen diese dabei fast parallel zum Querprofil 13 des Gestänges 8.

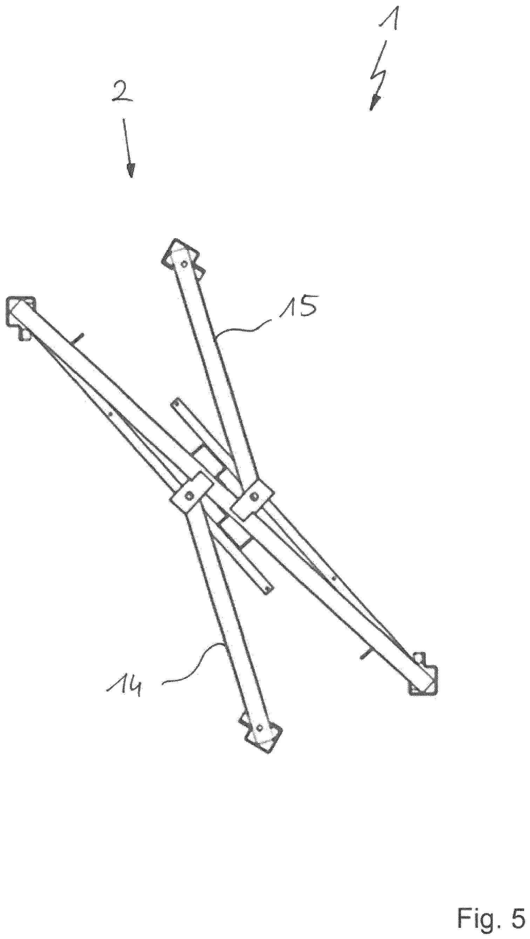

Fig. 5 ist der Beginn des anschließenden Schwenkens der beiden Ausleger 14, 15 in Richtung des Querprofils 13 zu entnehmen.

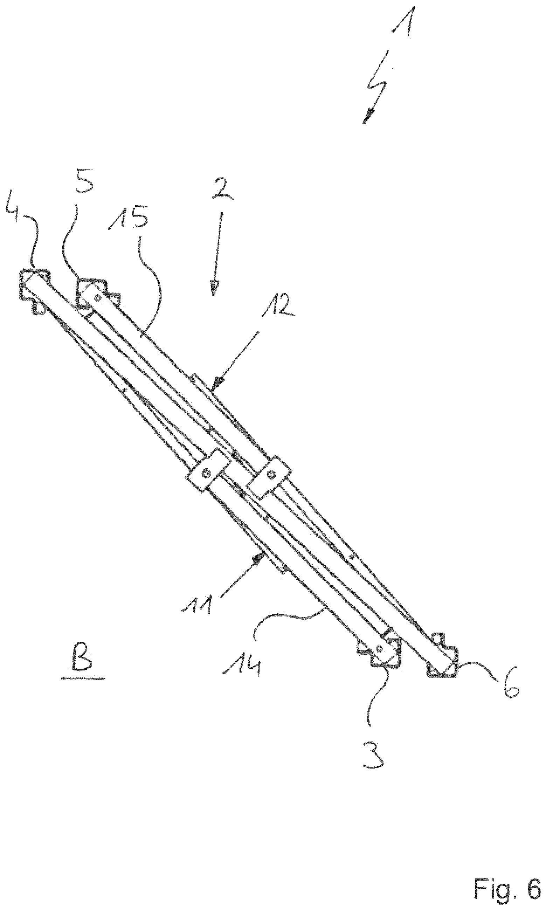

Fig. 6 verdeutlicht den Transportzustand B des Racks 1, indem die beiden Innenrahmen 11, 12 und die beiden Ausleger 14, 15 mitsamt der mit diesen verbundenen Längsprofilen 3, 5 mittels Schwenken vollständig eingeklappt sind. Erkennbar sind die äußeren Abmessungen des Gestells 2 und insofern des Racks 1 im Vergleich zum Gebrauchszustand A nunmehr deutlich reduziert. Zum Aufbau des Racks 1 erfolgen die zuvor beschriebenen Schritte in entsprechend umgekehrter Reihenfolge.

Fig. 7 zeigt das Rack 1 nochmals in perspektivischer Darstellung im Transportzustand B.

Durch Verkleiden des Racks 1 in einer hier nicht näher gezeigten Weise mit wenigstens einem Wandelement und/oder Türelement ist dieses zu einem erfindungsgemäßen Server- oder Netzwerkschrank ausbaubar.

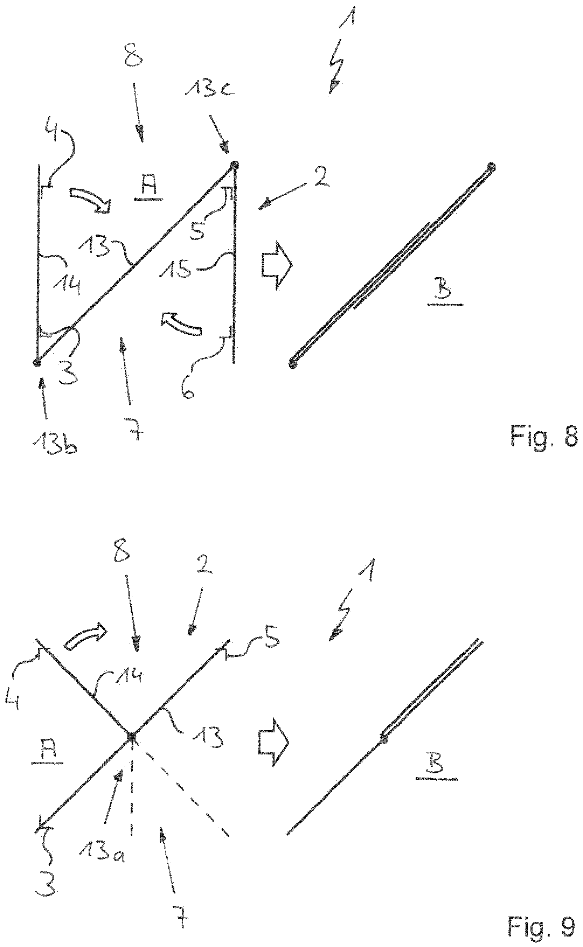

Fig. 8 zeigt eine erste alternative Ausgestaltung des erfindungsgemäßen Racks 1 in einer Aufsicht auf das Gestell 8. Auch zu dieser und den im weiteren Verlauf näher erläuterten alternativen Ausgestaltungen gelten die zu dem dabei jeweils ersichtlichen ersten Gestänge 8 gemachten Ausführungen für das - verdeckte und insofern nicht ersichtliche - zweite Gestänge 9 entsprechend.

Aus Gründen der Übersichtlichkeit und zur besseren Erläuterung wurden die jeweiligen Varianten dabei im ausgeklappten Gebrauchszustand A (Darstellung jeweils links) und im demgegenüber eingeklappten Transportzustand B (Darstellung jeweils rechts) unmittelbar nebeneinandergestellt und auf das eigentliche Gestell 2 reduziert. Dabei können die einzelnen Racks 1 nicht näher gezeigte Innenrahmen 11, 12 besitzen oder nicht, wobei in Abwesenheit der Innenrahmen 11, 12 die Längsprofile 3-6 selbst ebenfalls nicht näher ersichtliche Mittel zur Aufnahme von Geräten oder Baugruppen aufweisen können. Die gebogenen Pfeile stehen dabei für die mögliche Schwenkrichtung von Teilen des jeweiligen Racks 1. Der gerade Pfeil zwischen diesen Darstellungen verdeutlicht die jeweils beschriebene Veränderung vom Gebrauchszustand A hin zum Transportzustand B, wobei durch dessen Umkehrung und entsprechend entgegengesetzte Schwenkrichtungen der eingenommene Transportzustand B wieder zum Gebrauchszustand A hin veränderbar ist.

Wie in Fig. 8 zu erkennen, weist das Gestell 8 der ersten Variante des Racks 1 eine Positionieranordnung 7 auf, bei der die beiden Ausleger 14, 15 im Bereich der freien Enden 13b, 13c des Querprofils 13 gelenkig an diesem angeordnet sind. Im Gebrauchszustand A bilden die Ausleger 14, 15 zusammen mit dem Querprofil 13 in der hier gezeigten Aufsicht eine Z-Form. Gegenüber der zuvor beschriebenen Ausgestaltung des erfindungsgemäßen Racks 1 sind die Ausleger 14, 15 entsprechend länger ausgestaltet, um die Längsprofile 3-6 im Gebrauchszustand A in den Eckpunkten des dabei im Querschnitt rechteckigen Gestells 2 zu positionieren.

Fig. 9 ist eine zweite alternative Ausgestaltung des erfindungsgemäßen Racks 1 in einer Aufsicht auf das Gestell 8 zu entnehmen. Im Gegensatz zu den vorherigen Ausführungen weist das Gestänge 8 dabei nur einen einzelnen Ausleger 14 auf, der im mittleren Abschnitt 13a des Querprofils 13 gelenkig an diesem angeordnet ist. Die sich in der Aufsicht ergebende Y-Form des Gestells 2 kommt folglich mit nur drei Längsprofilen 3-5 aus. Die mit unterbrochenen Linien angedeuteten Positionen verdeutlichen alternative Lagen des Querprofils 13 beziehungsweise des Auslegers 14. Diese Variante ist die einzige, bei der etwaige Geräte oder Baugruppen nur von einer Seite aus in das Rack 1 eingesetzt und aus diesem entnommen werden können, während die anderen Varianten einen Zugang von zwei gegenüberliegenden Seiten aus ermöglichen.

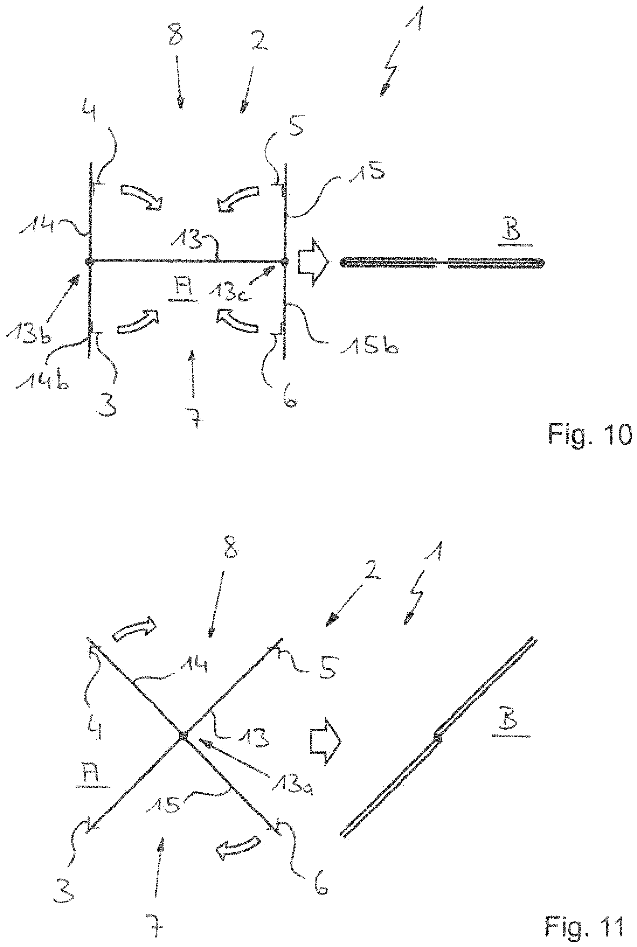

Fig. 10 offenbart eine dritte alternative Ausgestaltung des erfindungsgemäßen Racks 1 in einer Aufsicht auf das Gestell 8. Diese umfasst insgesamt vier Ausleger 14, 14b; 15, 14b, die jeweils paarweise im Bereich der beiden freien Enden 13b, 13c des Querprofils 13 gelenkig an diesem angeordnet sind. Gegenüber allen anderen Varianten können die Ausleger 14, 14b; 15, 14b hierbei die kürzeste Ausgestaltung aufweisen, um die Längsprofile 3-6 in den Eckpunkten des dabei im Querschnitt rechteckigen Gestells 2 zu positionieren.

Fig. 11 entspricht im Wesentlichen zur eingangs beschriebenen Ausgestaltung des erfindungsgemäßen Racks 1 in einer Aufsicht auf das Gestell 8. In dieser vierten alternativen Ausgestaltung sind die beiden Ausleger 14, 15 dabei quasi gegenüberliegend und insofern nicht versetzt zueinander an dem mittleren Abschnitt 13a des Querprofils 13 gelegen und gelenkig mit diesem verbunden.

### Bezugszeichen:

- 1: Rack
- 2: Gestell von 1
- 3: Längsprofil von 2
- 3a: erster Endabschnitt von 3
- 3b: zweiter Endabschnitt von 3
- 4: Längsprofil von 2
- 4a: erster Endabschnitt von 4
- 4b: zweiter Endabschnitt von 4
- 5: Längsprofil von 2
- 5a: erster Endabschnitt von 5
- 5b: zweiter Endabschnitt von 5
- 6: Längsprofil von 2
- 6a: erster Endabschnitt von 6
- 6b: zweiter Endabschnitt von 6
- 7: Positionieranordnung von 2
- 8: Gestänge von 7
- 9: Gestänge von 7
- 10: Innenraum von 2 bzw. 1
- 11: Innenrahmen von 1
- 11a: Pfosten von 11
- 11b: Pfosten von 11
- 11c: Riegel von 11
- 11d: Riegel von 11
- 12: Innenrahmen von 1
- 12a: Pfosten von 12
- 12b: Pfosten von 12
- 12c: Riegel von 12
- 12d: Riegel von 12
- 13: Querprofil von 8 und 9
- 13a: mittlerer Abschnitt von 13
- 13b: freies Ende von 13
- 13c: freies Ende von 13
- 14: Ausleger von 8 und 9
- 14a: freies Ende von 14
- 14b: Ausleger von 8 und 9
- 15: Ausleger von 8 und 9
- 15a: freies Ende von 15
- 15b: Ausleger von 8 und 9

- A: Gebrauchszustand von 1
- B: Transportzustand von 1
- x1: Längsrichtung von 3
- x2: Längsrichtung von 4
- x3: Längsrichtung von 5
- x4: Längsrichtung von 6

## Patentansprüche

1. Rack (1), insbesondere-Serverrack oder Netzwerkrack, umfassend ein Gestell (2) mit vier gegenüberliegend angeordneten Längsprofilen (3-6) sowie eine die Längsprofile (3-6) miteinander verbindende Positionieranordnung (7), welche derart beweglich ausgebildet ist, dass die mit der Positionieranordnung (7) verbundenen Längsprofile (3-6) relativ zueinander verlagerbar sind, **dadurch gekennzeichnet,**
**dass** die Positionieranordnung (7) zwei Gestänge (8, 9) umfasst, von denen das erste Gestänge (8) mit an einem ersten Ende (E1) des Gestells (2) gelegenen Endabschnitten (3a-6a) der Längsprofile (3-6) verbunden ist und das zweite Gestänge (9) mit an einem dem ersten Ende (E1) gegenüberliegenden zweiten Ende (E2) des Gestells (2) gelegenen Endabschnitten (3b-6b) der Längsprofile (3-6) verbunden ist, während jedes dieser Gestänge (8, 9) ein Querprofil (13) sowie zwei an einem, insbesondere mittleren, Abschnitt (13a) des jeweiligen Querprofils (13), insbesondere zueinander versetzt, schwenkbar angeordnete Ausleger (14, 15) besitzt und die freien Enden (13b, 13c; 14a, 15a) des Querprofils (13) sowie der Ausleger (14, 15) jedes Gestänges (8, 9) mit dem zugehörigen Endabschnitt (3a-6a, 3b-6b) eines Längsprofils (3-6), insbesondere biegesteif, verbunden sind, wobei zwei der in einem festen Abstand diagonal gegenüberliegend angeordneten Längsprofile (4, 6) mit den freien Enden (13b, 13c) des Querprofils (13) jedes Gestänges (8, 9) verbunden sind, während die übrigen zwei Längsprofile (3, 5) jeweils mit dem freien Ende (14a, 15a) des zugehörigen Auslegers (14, 15) jedes Gestänges (8, 9) verbunden sind.

2. Rack (1) nach Anspruch 1,
**dadurch gekennzeichnet,**
**dass** wenigstens ein Teil der Positionieranordnung (7) quer zur Längsrichtung (x) wenigstens eines der, insbesondere parallel zueinander ausgerichteten, Längsprofile (3-6) schwenkbar ist.

3. Rack (1) nach Anspruch 1 oder 2,
**gekennzeichnet durch**
zwei zur Aufnahme von Einschüben ausgebildete Innenrahmen (11, 12), welche jeweils zwei Pfosten (11a, 11b; 12a, 12b) und zwei die Pfosten (11a, 11b; 12a, 12b) miteinander verbindende Riegel (11c, 11d; 12c, 12d) besitzen, wobei die Innenrahmen (11, 12), insbesondere schwenkbar, an der Positionieranordnung (7) befestigt sind.

4. Rack (1) nach Anspruch 3,
**dadurch gekennzeichnet,**
**dass** die Innenrahmen (11, 12) sich zwischen zwei von einander beabstandeten Gestängen (8, 9) der Positionieranordnung (7) erstrecken.

5. Rack (1) nach Anspruch 4,
**dadurch gekennzeichnet,**
**dass** die Innenrahmen (11, 12) mit zwischen der Positionieranordnung (7) und jedem Längsprofil (3-6) angeordneten Knotenblechen gekoppelt oder koppelbar sind.

6. Rack (1) nach einem der vorhergehenden Ansprüche,
**dadurch gekennzeichnet,**
**dass** die Längsprofile (3-6) verdrehfest mit der Positionieranordnung (7) verbunden sind.

7. Server- oder Netzwerkschrank, umfassend ein Rack (1) nach einem der vorhergehenden Ansprüche und wenigstens ein das Rack (1) zumindest bereichsweise verkleidendes Wandelement und/oder Türelement.

## Claims

1. Rack (1), in particular a server rack or network rack, comprising a framework (2) with four longitudinal profiles (3-6) arranged opposite one another, as well as a positioning arrangement (7) which connects the longitudinal profiles (3-6) to one another and which is designed to be movable so that the longitudinal profiles (3-6) which are connected to the positioning arrangement (7) are displaceable relative to one another,
**characterised in**
**that** the positioning arrangement (7) comprises two rods (8, 9) of which the first rod (8) is connected to end portions (3a-6a) of the longitudinal profiles (3-6) located at a first end (E1) of the framework (2), and the second rod (9) is connected to end portions (3b-6b) of the longitudinal profiles (3-6) located at a second end (E2) of the framework (2) opposite the first end (E1), whilst each of these rods (8, 9) has a transverse profile (13) as well as two booms (14, 15) pivotably arranged on an, in particular, centre portion (13a) of the respective transverse profile (13), in particular offset relative to one another, and the free ends (13b, 13c; 14a, 15a) of the transverse profile (13) as well as the booms (14, 15) of each rod (8, 9) are connected, in particular in a rigid manner, to the associated end portion (3a-6a, 3b-6b) of a longitudinal profile (3-6), wherein two of the longitudinal profiles (4, 6) arranged diagonally opposite one another at a fixed spacing are connected to the free ends (13b, 13c) of the transverse profile (13) of each rod (8, 9), whilst the remaining two longitudinal profiles (3, 5) are each connected to the free end (14a, 15a) of the associated boom (14, 15) of each rod (8, 9).

2. Rack (1) according to claim 1
**characterised in**
**that** at least one part of the positioning arrangement (7) is pivotal transversely to the longitudinal direction (x) of at least one of the longitudinal profiles (3-6) which are oriented parallel to one another.

3. Rack (1) according to claim 1 or 2
**characterised by**
two internal frames (11, 12) which are configured for receiving inserts and which each have two uprights (11a, 11b; 12a, 12b) and two crossbars (11c, 11d; 12c, 12d) connecting the uprights (11a, 11b; 12a, 12b) to one another, wherein the internal frames (11, 12) are fixed in particular in pivotal manner on the positioning arrangement (7).

4. Rack (1) according to claim 3
**characterised in**
**that** the internal frames (11, 12) extend between two mutually spaced rods (8, 9) of the positioning arrangement (7).

5. Rack (1) according to claim 4
**characterised in**
**that** the internal frames (11, 12) are or can be coupled to gusset plates arranged between the positioning arrangement (7) and each longitudinal profile (3-6).

6. Rack (1) according to one of the preceding claims
**characterised in**
**that** the longitudinal profiles (3-6) are connected to the positioning arrangement (7) secured against rotation.

7. Server or network cabinet comprising a rack according to one of the preceding claims and at least one wall element and/or door element covering the rack (1) in at least some areas.

## Revendications

1. Baie (1), surtout baie de serveur ou baie de réseau, comprenant un bâti (2) pourvu de quatre profilés longitudinaux (3-6) disposés en face les uns des autres ainsi qu'un arrangement de positionnement (7) qui relie les profilés longitudinaux (3-6) les uns aux autres, qui est configuré mobile de sorte que les profilés longitudinaux (3-6) reliés à l'arrangement de positionnement (7) peuvent être déplacés les uns par rapport aux autres,
**caractérisé en ce**
**que** l'arrangement de positionnement (7) comporte deux tiges (8, 9) dont la première tige (8) est reliée à des parties terminales (3a-6a) des profilés longitudinaux (3-6) situées à une première extrémité (E1) de la bâti (2), et la deuxième tige (9) est reliée à des parties terminales (3b-6b) des profilés longitudinaux (3-6) situées à une deuxième extrémité (E1) de la bâti (2) opposée à la première extrémité (E1), tandis que chacune de ces tiges (8, 9) comporte un profil transversal (13) ainsi que deux bras (14, 15) montés de manière pivotante sur une section (13a), surtout centrale, du profil transversal (13) respectif, surtout décalés entre eux, et les extrémités libres (13b, 13c; 14a, 15a) du profil transversal (13) ainsi que le bras (14, 15) de chaque tige (8, 9) sont reliées, surtout résistants à la flexion, à la partie terminale (3a-6a, 3b-6b) correspondante d'un profilé longitudinal (3-6), dans lequel deux des profilés longitudinaux (3-6) agencés à une distance fixe diagonalement opposés sont reliés aux extrémités libres (13b, 13c) du profil transversal (13) de chaque tige (8, 9), tandis que les deux autres profilés longitudinaux (3-6) sont chacun reliés à l'extrémité libre (14a, 15a) du bras (14, 15) correspondant de chaque tige (8, 9).

2. Baie (1) selon la revendication 1,
**caractérisé en ce**
**qu'**au moins une partie de l'arrangement de positionnement (7) est pivotant transversalement à la direction longitudinale (x) de l'au moins un des profilés longitudinaux (3-6), surtout orientés parallèlement les uns aux autres.

3. Baie (1) selon la revendication 1 ou 2,
**caractérisé par**
deux cadres intérieurs (11, 12) conçus pour recevoir des tiroirs, comportant chacun deux poteaux (11a, 11b; 12a, 12b) et deux verrous (11c, 11d; 12c, 12d) reliant les poteaux (11a, 11b; 12a, 12b) entre eux, dans lequel les cadres intérieurs (11, 12) sont fixés à l'arrangement de positionnement (7) surtout de manière pivotante.

4. Baie (1) selon la revendication 3,
**caractérisé en ce**
**que** les cadres intérieurs (11, 12) s'étendent entre deux tiges (8, 9) de l'arrangement de positionnement (7) espacés les uns des autres.

5. Baie (1) selon la revendication 4,
**caractérisé en ce**
**que** les cadres intérieurs (11, 12) sont couplés ou peuvent être couplés à des goussets d'assemblage agencés entre l'arrangement de positionnement (7) et chaque profilé longitudinal (3-6).

6. Baie (1) selon l'une quelconque des revendications précédentes,
**caractérisé en ce**
**que** les profilés longitudinaux (3-6) sont reliés fixe en rotation à l'arrangement de positionnement (7) .

7. Armoire de serveur ou de réseau, comportant un baie (1) selon l'une quelconque des revendications précédentes et au moins un élément de paroi et/ou élément de porte couvrant le baie (1) au moins par endroits.
